# EUROPEAN PATENT SPECIFICATION

(11) **EP 1 918 954 B1**
(45) Date of publication and mention of the grant of the patent: **06.05.2009**
(21) Application number: 07119618.2
(22) Date of filing: 30.10.2007
(51) Int. Cl.: H01H 13/702, H01H 13/83

(54) **Keypad Assembly**
Tastaturanordnung
Ensemble de clavier

(30) Priority: 30.10.2006 KR 20060105675; 30.11.2006 KR 20060120144
(43) Date of publication of application: 07.05.2008
(73) Proprietor: Samsung Electronics Co., Ltd., Suwon-si, Gyeonggi-Do (KR)
(72) Inventor: Han, Dong-Kyoon, Yeongtong-gu, Suwon-si, Gyeonggi-do (KR)
(74) Representative: Grünecker, Kinkeldey, Stockmair & Schwanhäusser Anwaltssozietät

(56) References cited:
- EP-A- 1 197 835
- JP-A- 2006 147 519
- KR-B1- 100 606 081
- US-A1- 2003 210 537
- US-A1- 2005 030 048
- US-B1- 6 861 600

## Description

### BACKGROUND OF THE INVENTION

### 1. Field of the Invention

The present invention relates to a keypad, and more particularly to a keypad having a rear lighting means and a keypad assembly including the same.

### 2. Description of the Related Art

As generally known in the art, keypads and keypad assemblies are widely used as the input device of domestic appliances and mobile communication devices as they employ dome switches for simple structure and as they have excellent reliability. The dome switch-type keypad assemblies enable a user to recognize the repulsive force generated from the dome switches and to recognize whether a particular key button is pressed.

Keypad assemblies have a background lighting means directed towards key buttons so that a user is provided with lighting when the keypad assemblies are used in the dark. As the background lighting means, a plurality of light sources are generally positioned on dome switches so that light is directed from the light sources to key buttons (i.e. rear lighting type).

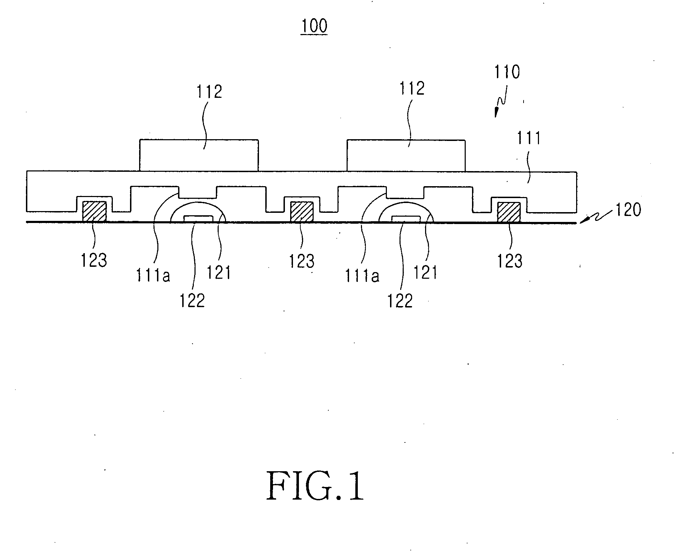

FIG. 1 shows the section of a keypad assembly having a rear lighting means according to the prior art. Referring to FIG. 1, the conventional keypad assembly 100 includes a keypad 110 and a switch board 120 positioned beneath the keypad 110.

The keypad 110 includes at least one key button 112 and an elastic layer 111 positioned beneath the key button 112. The elastic layer 111 has protrusions 111a formed on a surface of the elastic layer 111 that faces the switch board 120, and the protrusions 111a correspond to respective key buttons 112.

The key buttons 112 have characters, symbols, numerals, or special characters printed, or otherwise provided, on their upper surface, respectively, so that the user can press particular key buttons 112 and input information. The elastic layer 111 restores the key buttons 112 to their original positions after they are pressed. The protrusions 111a maximize the user's feel when pressing the key buttons 112.

The switch board 120 has dome switches 121 positioned to correspond to respective key buttons 112, as well as a plurality of light sources 123. The switch board 120 may be a printed circuit board having a plurality of electric contacts 122 and an electric circuit pattern formed thereon. Alternatively, the switch board 120 may be a printed circuit board with a dome sheet, which has a plurality of dome switches 121, attached to the board.

The dome switches 121 are thin plates made of a conductive material (e.g. metal). When the key buttons 112 are pressed, the dome switches 121 abut corresponding electric contacts 122 and establish electric connections.

The protrusions 111a and the dome switches 121 are vertically aligned with corresponding key buttons 112. When a specific key button 112 is pressed, corresponding protrusion 111a and dome switch 121 establish an electric connection and enable information input.

Document EP 1 197 835 A2 describes a keypad assembly according to the preamble of claims 1, 10 and 17.

The conventional keypad assemblies, however, are not ideal for portable electronic devices (e.g. portable communication terminals). One deficiency of the conventional keypad assemblies is that they require a large number of light sources, as rear light means, that emit light towards key buttons for uniform luminance. As such, the conventional keypad assemblies are not ideal for portable electronic devices that are required to consume little power and to occupy a small area.

To remedy this defect, it has been proposed to insert a waveguide between the keypad and the switch board as a rear lighting means. However, this approach would result in keypad assemblies with a large thickness.

### SUMMARY OF THE INVENTION

Accordingly, the present invention has been made to solve the above-mentioned problems occurring in the prior art and to provide additional advantages. In particular, the present invention provides a keypad assembly that has a small thickness, little power consumption, and low manufacturing cost.

One aspect of the present invention provides a keypad assembly including: a keypad; a touch sensor having a light-guiding plate, the touch sensor being positioned beneath the keypad so as to reflect light incident on the light-guiding plate towards the keypad; and a switch member positioned beneath the touch sensor.

Another aspect of the present invention provides a keypad assembly including: a touch sensor including a light-guiding plate, upper electrodes positioned on an upper surface of the light-guiding plate, an upper clad covering the upper surface of the light-guiding plate together with the upper electrodes, a lower electrode positioned on a lower surface of the light-guiding plate, and a lower clad formed on the lower surface of the light-guiding plate; and a switch member positioned beneath the touch sensor.

Another aspect of the present invention provides a keypad assembly including: a touch sensor including a light-guiding plate, an upper electrode positioned on an upper surface of the light-guiding plate, and an upper clad formed so as to cover the upper surface of the light-guiding plate together with the upper electrode; a light source having a light-emitting surface facing a lateral surface of the light-guiding plate; a first printed circuit board extending from the touch sensor, the light source being mounted on a surface of the first printed circuit board; and a switch member positioned beneath the touch sensor.

### BRIEF DESCRIPTION OF THE DRAWINGS

The features and advantages of the present invention will be apparent from the following detailed description taken in conjunction with the accompanying drawings, in which:
FIG. 1 shows the section of a conventional keypad assembly;
FIGs. 2a to 2d show a keypad assembly according to a first embodiment of the present invention;
FIG. 3 shows the section of a keypad assembly according to a second embodiment of the present invention;
FIG. 4 shows the section of a keypad assembly according to a third embodiment of the present invention;
FIG. 5 shows the section of a keypad assembly according to a fourth embodiment of the present invention;
FIG. 6 shows the section of a keypad assembly according to a fifth embodiment of the present invention;
FIGs. 7a to 7c show a comparison between a keypad assembly according to the present invention and a conventional keypad assembly; and
FIGs. 8a and 8b show another comparison between a keypad assembly according to the present invention and a conventional keypad assembly.

### DETAILED DESCRIPTION OF THE PRESENT INVENTION

Hereinafter, several embodiments of the present invention will be described with reference to the accompanying drawings. In the following description of the present invention, a detailed description of known functions and configurations incorporated is omitted, as such a description may make the subject matter of the present invention rather unclear. In addition, a detailed description of the similar components and configurations of the present invention is not repeated for the purposes of clarity and brevity.

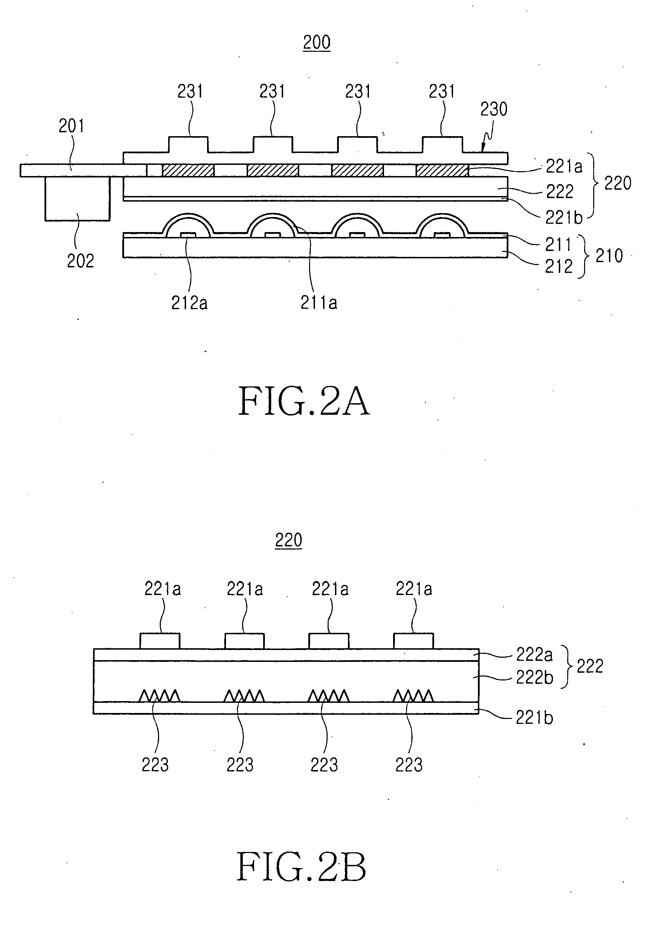

FIGs. 2a to 2d show a keypad assembly according to a first embodiment of the present invention. Referring to FIGs. 2a to 2d, the keypad assembly 200 includes a keypad 230; a touch sensor 220 having an upper surface, on which the keypad 230 is disposed; a switch member 210 disposed beneath the touch sensor 220; a light source 202; and a first printed circuit board 201.

The keypad 230 has at least one key button 231 formed on its upper surface. Each key button 231 contains a character, symbol, or numeral so that the user can select a desired key button 231 and input corresponding information.

The touch sensor 220 includes a light-guiding plate 222 made of, for example, a dielectric material. In addition, the touch sensor 220 includes upper and lower electrodes 221a and 221b disposed on opposite sides of the light-guiding plate 222. The touch sensor 220 may be an electrostatic capacity-type touch sensor, and may include a light-guiding plate 222 with a predetermined dielectric capacity so that it can sense the change of electric field created between the upper and lower electrodes 221a and 221b. The electrostatic capacity-type touch sensor 220 according to the present invention may be adapted to sense the change of electrostatic capacity resulting from the user's pressing or touching.

The touch sensor 220 may also have electrodes formed on only one surface of the light-guiding plate 222 and the lower electrode 221b of the light-guiding plate 222 may be omitted from the light-guiding plate 222. In such a case, the touch sensor 220 is adapted to sense the change of electrostatic capacity between upper electrodes 221a, which are formed on the touch sensor 220, and the user's finger, for example, that may act as the other electrode layer.

The light-guiding plate 222 may be made of glass or polymer, such as polycarbonate, polyimide, or polyethylene terephthalate (PET). The light-guiding plate 222, in addition to maintaining the electric field, guides light incident on one lateral surface of the light-guiding plate 222 to the opposite lateral surface, and reflect a portion of the light towards the keypad.

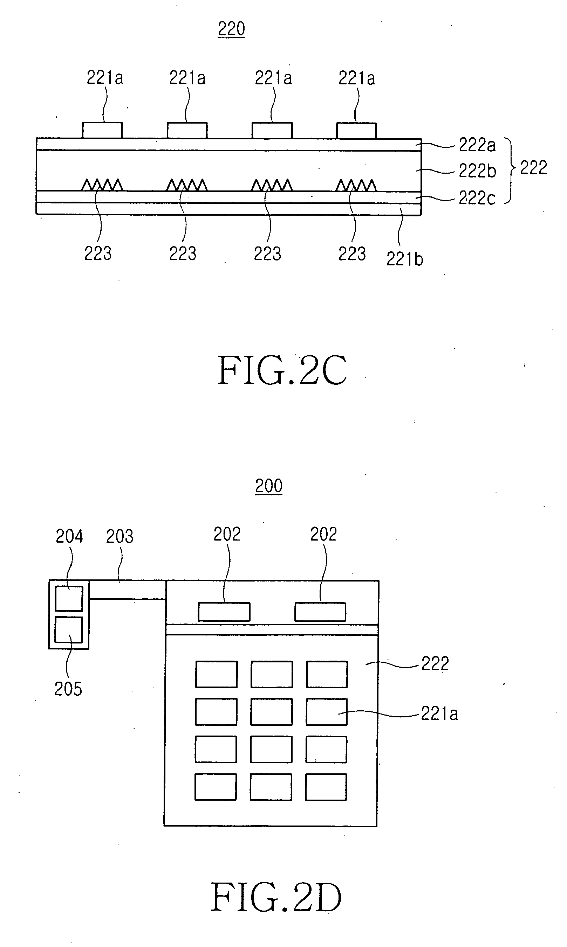

FIGs. 2b and 2c show exemplary configurations of the light-guiding plate.

FIG. 2b represents a magnification of an example of the touch sensor 220 shown in FIG. 2a. In particular, FIG. 2b shows an example of the touch sensor 220 that has an upper electrode 221a, but not a separate lower electrode. As shown in FIG. 2b, the light-guiding plate 222 includes a core 222b, a clad 222a formed on top of the core 222b, and reflection patterns 223 formed on portions of the core 222b. The core 222b has a refractive index higher than that of the upper clad 222a and the lower electrode 221b so that light incident on the light-guiding plate 222 is guided through the plate 222 as the light is totally reflected at the interface between the upper clad 222a and the lower clad 221b.

FIG. 2c shows another exemplary configuration of the touch sensor 220 that includes upper and lower electrodes 221a and 221b. The touch sensor 220 shown in FIG. 2c also includes the light-guiding plate 222, where the light-guiding plate 222 includes a core 222b; an upper clad 222a disposed on top of the core 222b; a lower clad 222c disposed beneath the core 222b; and reflection patterns 223 disposed on the interface between the lower clad 222c and the core 222b. The upper and lower clads 222a and 222c have a refractive index lower than that of the core 222b.

The reflection patterns 223, which correspond to the key buttons 231 of the keypad 230, may be disposed on portions of the core 222b by molding, stamping, scratching, or printing. Alternatively, the reflection patterns 223 may be integrated onto the light-guiding plate 222, when the light-guiding plate 222 is molded by extrusion. The reflection patterns 223 irregularly reflect a portion of light, which is incident on a lateral surface of the light-guiding plate 222, towards the keypad 230. As such, the reflection patterns 223 act as rear lighting means for the keypad 230.

Instead of using the reflection patterns 223, it is also possible to attach an adhesive film layer, which has desired light-emitting patterns formed thereon, to the interface of the core 222b so as to locally prevent the total reflection condition at some portions of the light-guiding plate 222.

The upper electrodes 221a are formed on the light-guiding plate 222, and the lower electrode 221b is formed beneath the light-guiding plate 222. The upper and lower electrodes 221a and 221b may be made of a conductive transparent material, ITO for example, or a conductive polymer that is transparent in the visible wavelength band. The upper and lower electrodes 221a and 221b are electrically connected to the first printed circuit board 201.

The first printed circuit board 201 is bonded to the touch sensor 220 and positioned beneath the keypad 230. The light source 202 may be mounted on the lower surface of the first printed circuit board 201 such that the light source 202 emits light laterally to the touch sensor 220. The first printed circuit board 201 may be a flexible printed circuit board.

The switch member 210 includes a second printed circuit board 212 having at least one electric contact 212a, and a dome sheet 211 disposed on the second printed circuit board 212 and provided with domes 211a corresponding to the electric contacts 212a. When the user selects and presses the key buttons 231, respective domes 211a establish electric connections with corresponding electric contacts 212a.

FIG. 2d is a top view of the keypad assembly 200 according to the first aspect of the present invention. As shown, the keypad assembly 200 is connected to a controller 204 that controls the touch sensor 220, as well as a connector 205 that connects the keypad assembly 200 to a main board (not shown) via, for example, a separate flexible printed circuit board 203. The controller 204 may be positioned on the first printed circuit board 201 depending on design requirements. The thickness of the first printed circuit board 201 may be equal to or somewhat different from that of the light-guiding plate 222. In the case of a portable communication terminal or digital device, the thickness is generally 0.05-0.5mm.

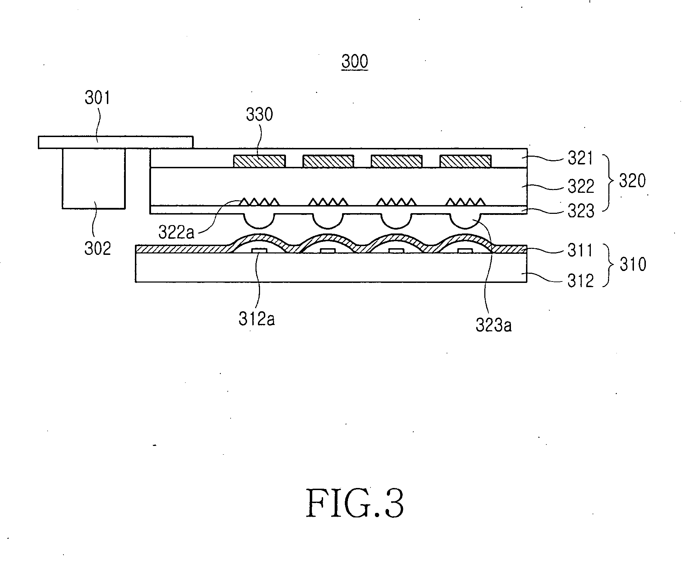

FIGs. 3 to 6 illustrate other embodiments of the present invention. It is noted that a detailed description of the components illustrated in FIGs. 3 to 6 that are similar to those illustrated in FIG. 2a is not repeated for the purposes of clarity and brevity.

FIG. 3 shows a keypad assembly according to a second embodiment of the present invention. Referring to FIG. 3, the keypad assembly 300 according to the second embodiment of the present invention includes a touch sensor 320; a switch member 310; a light source 302; and a first printed circuit board 301.

The touch sensor 320 includes a light-guiding plate 322 as a waveguide; a lower clad 323 disposed on the lower surface of the light-guiding plate 322; upper electrodes 330 disposed on the upper surface of the light-guiding plate 322; and an upper clad 321 covering the upper surface of the light-guiding plate 322 together with the upper electrodes 330. The light-guiding plate 322 maintains the electric field established between the upper electrodes 330 and the lower clad 323 and guides incident light from the light source 302.

The upper and lower clads 321 and 323 are made of, for example, a transparent material having an optical refractive index lower than that of the light-guiding plate 322 in the visible ray domain. The upper and lower clads 321 and 323 maintain the condition for guiding light incident on the light-guiding plate 322, regardless of the boundary condition. The lower clad 323 has protrusions 323a that are positioned so as to correspond to the upper electrodes 330 and are directed to the switch member.

The reflection patterns 322a, which correspond to the upper electrodes 330, are disposed on inner portions of the light-guiding plate 322 so as to reflect a portion of incident light towards the upper electrodes 330.

The switch member 310, disposed beneath the lower clad 323 includes a second printed circuit board 312 and a dome sheet 311. The second printed circuit 312 has at least one electric contact 312a, and the dome sheet 311, disposed on the second printed circuit board 312, is provided with domes that correspond with the electric contacts 312a. When the user selects and presses particular key buttons, respective domes establish electric connections with corresponding electric contacts 312a.

The light source 302 has a light-emitting surface facing a lateral surface of the light-guiding plate 322 so that light emitted from the light-emitting surface is input to the light-guiding plate 322. The input light is guided through the waveguide 322, and a portion of the guided light is reflected towards the upper electrodes 330. The light source 302 is mounted on a surface of the printed circuit board 301, and the first printed circuit board 301 may be connected to the light-guiding plate 322 of the touch sensor 320 based on bonding to wirings (not shown) disposed on top of the light-guiding plate 322.

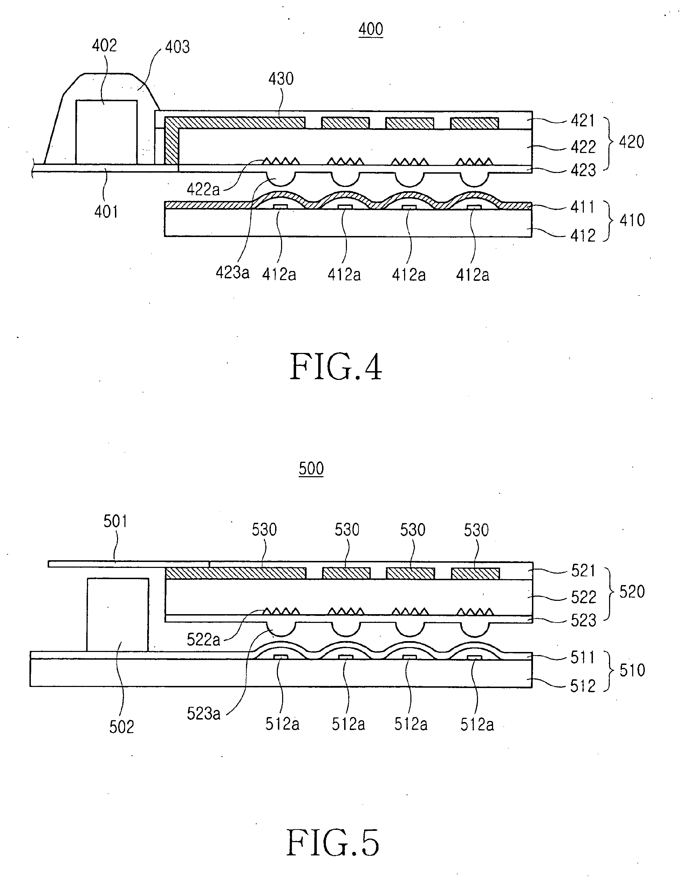

FIG. 4 shows a keypad assembly according to a third embodiment of the present invention. Referring to FIG. 4, the keypad assembly 400 according to the present embodiment includes a touch sensor 420; a switch member 410; a light source 402; and a first printed circuit board 401.

The touch sensor 420 of the keypad assembly 400 includes a light-guiding plate 422; a lower clad 423 disposed on the lower surface of the light-guiding plate 422; upper electrodes 430 disposed on the upper surface of the light-guiding plate 422; and an upper clad 421 covering the upper surface of the light-guiding plate 422 together with the upper electrodes 430. The light-guiding plate 422 has at least one reflection pattern 422a formed on a portion thereof.

The lower clad 423 has protrusions 423a that are positioned so as to correspond to the upper electrodes 430 and that protrude vertically in direction to the switch member.

The switch member 410 disposed beneath the lower clad 423 includes a second printed circuit board 412 and a dome sheet 411. The second printed circuit board 412 has at least one electric contact 412a, and the dome sheet 411, disposed on the second printed circuit board 412, is provided with domes corresponding to the electric contacts 412a.

The light source 402 is seated on the first printed circuit board 401. In particular, the light source 402 may be fixed to the first printed circuit board 401 by, for example, applying epoxy 403 so as to cover the light source 402. The epoxy 403 has a refractive index selected in conformity with the light-guiding plate 422 so that the loss of reflected light is minimized when light from the light source 402 is incident on the light-guiding plate 422. As such, the epoxy 403 may improve the brightness of rear lighting by minimizing the coupling loss of light based on refractive index matching.

According to the present embodiment of the present invention, it is also possible to apply, for example, opaque paint to the upper surface of the epoxy 403 after the epoxy 403 is cured in order to prevent light scattered outwards from the interface between the light source 402 and the light-guiding plate 422. The first printed circuit board 401 extends from the touch sensor 420, and the first printed circuit board 401 may be electrically connected to the upper electrodes 430 through via-holes extending through the light-guiding plate 422.

FIG. 5 shows a keypad assembly according to a fourth embodiment of the present invention. Referring to FIG. 5, the keypad assembly 500 according to the present embodiment includes a touch sensor 520, a switch member 510, a light source 502, and a first printed circuit board 501.

The touch sensor 520 of the keypad assembly 500 includes a light-guiding plate 522; a lower clad 523 disposed on the lower surface of the light-guiding plate 522; upper electrodes 530 disposed on the upper surface of the light-guiding plate 522; and an upper clad 521 covering the upper surface of the light-guiding plate 522 together with the upper electrodes 530. The light-guiding plate 522 has at least one reflection pattern 522a formed on a portion thereof.

The lower clad 523 has protrusions 523a that are positioned to correspond to the upper electrodes 530 and that protrude vertically in direction to the switch member.

The switch member 510 disposed beneath the lower clad 523 includes a second printed circuit board 512 and a dome sheet 511. The second printed circuit board 512 has at least one electric contact 512a, and the dome sheet 511, disposed on the second printed circuit board 512, is provided with domes corresponding to the electric contacts.

The light source 502 is disposed on the switch member 510 with its light-emitting surface facing a lateral surface of the light-guiding plate 522. The first printed circuit board 501 is electrically connected to the touch sensor 520.

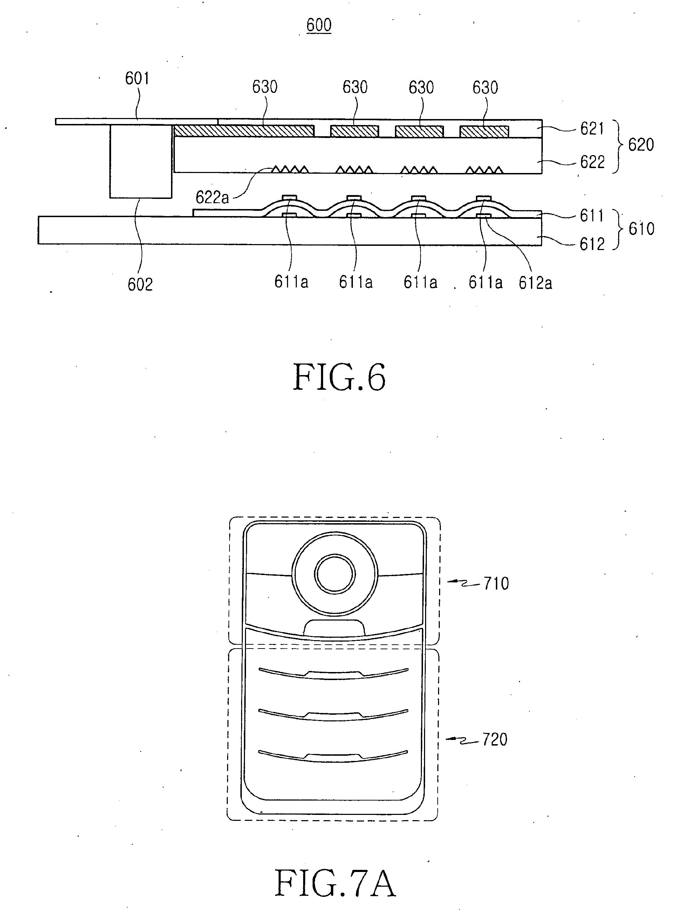

FIG. 6 shows a keypad assembly according to a fifth embodiment of the present invention. Referring to FIG. 6, the keypad assembly 600 according to the present embodiment includes a touch sensor 620; a switch member 610; a light source 602; and a first printed circuit board 601.

The touch sensor 620 of the keypad assembly 600 includes a light-guiding plate 622; upper electrodes 630 disposed on the upper surface of the light-guiding plate 622; and an upper clad 621 covering the upper surface of the light-guiding plate 622 together with the upper electrodes 630. The light-guiding plate 622 has at least one reflection pattern 622a formed on a portion thereof.

The switch member 610 is disposed beneath the light-guiding plate 622 and includes a second printed circuit board 612 and a dome sheet 611. The second printed circuit board 612 has at least one electric contact 612a, and the dome sheet 612, disposed on the second printed circuit board 612, is provided with domes corresponding to the electric contacts. Each dome has a protrusion 611a formed thereon.

The first printed circuit board 601 is electrically connected to the touch sensor 620. The light source 602 is mounted on a surface of the first printed circuit board 601 with its light-emitting surface facing a lateral surface of the light-guiding plate 622.

According to the embodiments shown in FIGs. 2a to 6, the touch sensor and the switch member can establish their own electric contacts. In other words, the keypad assembly according to the present invention can selectively use electric contacts formed on the touch sensor or the switch member. In addition, the touch sensor guides light as a light-guiding plate.

FIGs. 7a to 7c show a comparison between a keypad assembly according to the present invention and a conventional keypad assembly. FIG. 7a shows the conventional keypad assembly, which includes a first part 710 with menu selection buttons and a second part 720 used by the user to input information (e.g. characters, numerals, or symbols).

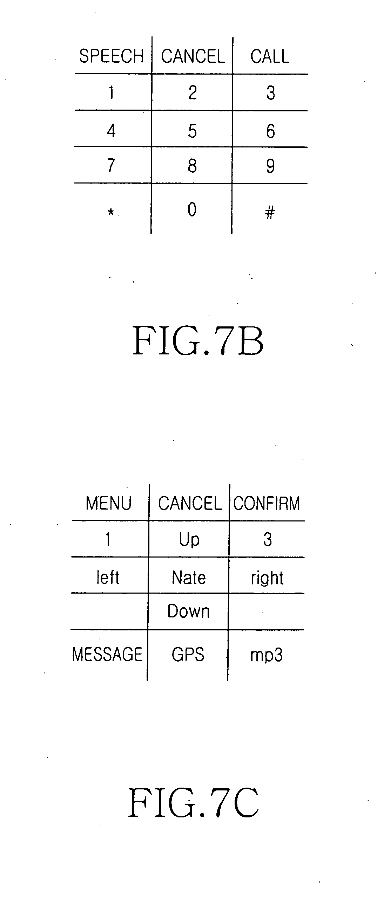

FIGs. 7b and 7c show an exemplary configuration based on the keypad assembly according to one of the first to fifth embodiments of the present invention. The keypad assembly can select electric contacts from the touch sensor or the switch member.

Therefore, the keypad assembly according to the present invention enables the user to input numerals or characters as shown in FIG. 7b. In addition, the same keypad assembly shown in FIG. 7b may be used as a menu button.

As such, the present invention enables the user to either input information or operate menu selection buttons with a single keypad assembly, which has a small area. Note that the present invention FIG. 7b and 7c shows the feature of providing a user with the various keys as the image information by using the keypad assembly of the touch screen, where as the keypad of the conventional art can provide the user with only one shape printed on the keypad assembly.

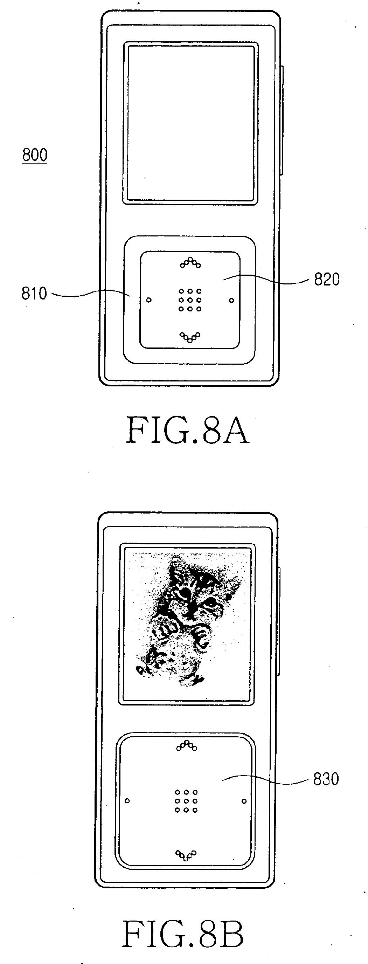

FIGs. 8a and 8b show another comparison of the keypad assembly according to the present invention and the conventional keypad assembly. FIG. 8a shows an example of a conventional portable electronic device, particularly a keypad assembly 800 having a touch sensor 820 and a dome-type switch member 810 separately arranged thereon. FIG. 8b, meanwhile, shows an example of a keypad assembly according to the present invention, where the touch sensor and the dome-type switch member is arranged vertically so that electric contacts can be selected as desired.

Comparing the keypad assembly shown in FIG. 8a, which has two separate switches disposed laterally, with that shown in FIG. 8b, which has two separate switches integrated vertically, the switch area of the present invention is reduced, and the rear lightning function is integrated without change in the thickness in the vertical direction.

As mentioned above, the keypad assembly according to the present invention has a light-guiding plate (transparent board), to which the touch sensor and the rear lighting means are integrated. This allows to dispose the dome-type switch member beneath the touch sensor and to provide the rear lighting means. As such, the inventive keypad assembly can provide rear lighting without increasing the thickness.

In addition, the fact that the dome-type switch member is positioned beneath the touch sensor enables the user to easily recognize whether or not key buttons are pressed correctly and select electric contacts from the touch sensor or the switch member as desired. Compared with conventional keypad assemblies having both buttons for selecting menus and buttons for inputting information or numerals, the keypad assembly of the present invention provides the user with both menu selection buttons and information input buttons even if the keypad assembly has a small area.

While the invention has been shown and described with reference to certain preferred embodiments thereof, it will be understood by those skilled in the art that various changes in form and details may be made therein without departing from the scope of the invention as defined by the appended claims.

## Claims

1. A keypad assembly comprising:
a keypad (230);
a touch sensor (220,320,420,520,620); and
a switch member (210,310,410,510,610) being disposed below the touch sensor, **characterized in that** the touch sensor has a light-guiding plate (222,322,422,522,622), having at least one first electrode (221a,330,430,530,630), and being disposed below the keypad so as to reflect light incident on the light-guiding plate towards the keypad,
wherein the at least one electrode is interposed between the light-guiding plate and the keypad.

2. The keypad assembly as claimed in claim 1, further comprising:
a light source (202,302,402,602) having a light-emitting surface that faces a lateral surface of the light-guiding plate (222,322,422,622); and
a first printed circuit board (201,301,401,601) supporting the light source relative to the light-guiding plate, the first printed circuit board being electrically connected to the touch sensor.

3. The keypad assembly as claimed in claim 1, wherein the touch sensor (220) comprises:
a second electrode (221b) disposed below the light-guiding plate (222).

4. The keypad assembly as claimed in claim 3, wherein the upper and lower electrodes (221a,b) are made of a conductive polymer, the conductive polymer being transparent in a wavelength band of visible rays.

5. The keypad assembly as claimed in claim 1, wherein the switch member (210,310,410,510,610) comprises:
a second printed circuit board (212,312,412,512,612) having at least one electric contact (212a,312a,412a,512a,612a); and
a dome sheet (211,311,411,511,611) being disposed on the second printed circuit board and being provided with domes (211 a) that correspond with the electric contacts.

6. The keypad assembly as claimed in claim 1, wherein the light-guiding plate comprises:
a core (222b);
an upper clad (221a,222a,321,421,521,621) disposed above the core; and
at least one reflection pattern (223,322a,422a,522a,622a).

7. The keypad assembly as claimed in claim 6, wherein the reflection pattern is being disposed on a portion of a surface of the core (222b) and being configured to irregularly reflect a portion of light incident on a lateral surface of the light-guiding plate towards the upper clad.

8. The keypad assembly as claimed in claim 7, wherein the light-guiding plate further comprises a lower clad (222c,323,423,523) disposed below the core.

9. The keypad assembly as claimed in claim 1, wherein the touch sensor is an electrostatic capacity-type touch sensor.

10. A keypad assembly comprising:
a touch sensor (220,320,420,520); and
a switch member (210,310,410,510) disposed below the touch sensor, **characterized in that** the touch sensor comprises a light-guiding plate (222,322,422,522); upper electrodes (221a,330,430,530) being disposed on an upper surface of the light-guiding plate; an upper clad (222a,321,421,521) covering the upper surface of the light-guiding plate together with the upper electrodes; a lower electrode (221b) being disposed on a lower surface of the light-guiding plate; and a lower clad (222c,323,423,523) being disposed on the lower surface of the light-guiding plate.

11. The keypad assembly as claimed in claim 10, wherein the upper and lower clads are made of a polymer having a refractive index lower than the light-guiding plate.

12. The keypad assembly as claimed in claim 10, wherein the lower clad (323,423,523) has protrusions (323a,423a,523a) extending in a vertically downward direction, the lower clad being disposed to correspond to the upper electrodes.

13. The keypad assembly as claimed in claim 10, further comprising:
a light source (202,302,402,602) having a light-emitting surface facing a lateral surface of the light-guiding plate; and
a first printed circuit board (201,301,401,601) extending from the touch sensor, the light source being mounted on a surface of the first printed circuit board.

14. The keypad assembly as claimed in claim 10, further comprising:
a light source (502) being disposed on the switch member (510), the light source having a light-emitting surface facing a lateral surface of the light-guiding plate; and
a first printed circuit board (501) electrically connected to the touch sensor (520).

15. The keypad assembly as claimed in claim 10, further comprising at least one reflection pattern (223,322a,422a,522a,622a) formed on a portion of the light-guiding plate (222,322,422,522,622).

16. The keypad assembly as claimed in claim 10, wherein the upper electrodes (221a,330,430,530,630) are made of a conductive polymer, the conductive polymer being transparent in a visible ray domain.

17. A keypad assembly comprising:
a touch sensor (220,320,420,620) and a switch member (210,310,410,610) positioned beneath the touch sensor, **characterized in that** the touch sensor comprises a light-guiding plate (222,322,422,622), an upper electrode (221a, 321, 421, 621) positioned on an upper surface of the light-guiding plate, and an upper clad (222a,321,421,621) being configured to cover the upper surface of the light-guiding plate together with the upper electrode; the keyboard assembly further comprising
a light source (202,302,402,602) having a light-emitting surface that faces a lateral surface of the light-guiding plate; and
a first printed circuit board (201,301,401,601) extending from the touch sensor, the light source being mounted on a surface of the first printed circuit board.

18. The keypad assembly as claimed in claim 17, wherein the switch member comprises:
a second printed circuit board (612) having at least one electric contact (612a) formed thereon;
a dome sheet (611) being disposed on the second printed circuit board (612) and being provided with domes (211a) that correspond with the electric contacts; and
protrusions (611a) disposed on respective domes.

19. The keypad assembly as claimed in claim 17, wherein the keypad assembly is adapted to selectively use electric contacts from one of the touch sensor and the switch member.

## Patentansprüche

1. Tastenfeldanordnung, die umfasst:
ein Tastenfeld (230);
einen Berührungssensor (220, 320, 420, 520, 620), und
ein Schalterelement (210, 310, 410, 510, 610), das unter dem Berührungssensor angeordnet ist, **dadurch gekennzeichnet, dass** der Berührungssensor eine Lichtleitplatte (222, 322, 422, 522, 622) aufweist, die wenigstens eine erste Elektrode (221 a, 330, 430, 530, 630) hat und unter dem Tastenfeld so angeordnet ist, dass sie Licht, das auf die Lichtleitplatte auftrifft, auf das Tastenfeld zu reflektiert,
wobei die wenigstens eine Elektrode zwischen der Lichtleitplatte und dem Tastenfeld angeordnet ist.

2. Tastenfeldanordnung nach Anspruch 1, die des Weiteren umfasst:
eine Lichtquelle (202, 302, 402, 602) mit einer Licht emittierenden Fläche, die einer seitlichen Fläche der Lichtleitplatte (222, 322, 422, 522, 622) zugewandt ist; und
eine erste Leiterplatte (201, 301, 401, 601), die die Lichtquelle relativ zu der Lichtleitplatte trägt, wobei die erste Leiterplatte elektrisch mit dem Berührungssensor verbunden ist.

3. Tastenfeldanordnung nach Anspruch 1, wobei der Berührungssensor (220) umfasst:
eine zweite Elektrode (221 b), die unter der Lichtleitplatte (222) angeordnet ist.

4. Tastenfeldanordnung nach Anspruch 3, wobei die obere und die untere Elektrode (221 a, b) aus einem leitenden Polymer bestehen und das leitende Polymer in einem Wellenlängenband sichtbarer Strahlen transparent ist.

5. Tastenfeldanordnung nach Anspruch 1, wobei das Schalterelement (210, 310, 410, 510, 610) umfasst:
eine zweite Leiterplatte (212, 312, 412, 512, 612), die wenigstens einen elektrischen Kontakt (212a, 312a, 412a, 512a, 612a) hat; und
eine Haubenfolie (dome sheet) (211, 311, 411, 511, 611), die auf der zweiten Leiterplatte angeordnet ist und mit Hauben (211a) versehen ist, die den elektrischen Kontakten entsprechen.

6. Tastenfeldanordnung nach Anspruch 1, wobei die Lichtleitplatte umfasst:
einen Kern (222b);
eine obere Ummantelung (221 a, 222a, 321, 421, 521, 621), die über dem Kern angeordnet ist; und
wenigstens ein Reflektionsmuster (223, 322a, 422a, 522a, 622a).

7. Tastenfeldanordnung nach Anspruch 6, wobei das Reflektionsmuster auf einem Abschnitt einer Oberfläche des Kerns (222b) angeordnet und so konfiguriert ist, dass es einen Teil des Lichtes, das auf eine seitliche Fläche der Lichtleitplatte auftrifft, unregelmäßig auf die obere Ummantelung zu reflektiert.

8. Tastenfeldanordnung nach Anspruch 7, wobei die Lichtleitplatte des Weiteren eine untere Ummantelung (222c, 323, 423, 523) umfasst, die unter dem Kern angeordnet ist.

9. Tastenfeldanordnung nach Anspruch 1, wobei der Berührungssensor ein elektrostatischer Kapazitäts-Berührungssensor ist.

10. Tastenfeldanordnung, die umfasst:
einen Berührungssensor (220, 320, 420, 520); und
ein Schalterelement (210, 310, 410, 510), das unter dem Berührungssensor angeordnet ist, **dadurch gekennzeichnet, dass** der Berührungssensor eine Lichtleitplatte (222, 322, 422, 522); obere Elektroden (221 a, 330, 430, 530), die an einer oberen Fläche der Lichtleitplatte angeordnet sind; eine obere Ummantelung (222a, 321, 421, 521), die die obere Fläche der Lichtleitplatte zusammen mit den oberen Elektroden abdeckt; eine untere Elektrode (221 b), die an einer unteren Fläche der Lichtleitplatte angeordnet ist, und eine untere Ummantelung (222c, 323, 423, 523) umfasst, die an der unteren Fläche der Lichtleitplatte angeordnet ist.

11. Tastenfeldanordnung nach Anspruch 10, wobei die obere und die untere Ummantelung aus einem Polymer bestehen, das einen Brechungsindex hat, der niedriger ist als der der Lichtleitplatte.

12. Tastenfeldanordnung nach Anspruch 10, wobei die untere Ummantelung (323, 423, 523) Vorsprünge (323a, 423a, 523a) aufweist, die sich in einer vertikal nach unten verlaufenden Richtung erstrecken, und die untere Ummantelung so angeordnet ist, dass sie den oberen Elektroden entspricht.

13. Tastenfeldanordnung nach Anspruch 10, die des Weiteren umfasst:
eine Lichtquelle (202, 302, 402, 602) mit einer Licht emittierenden Fläche, die einer seitlichen Fläche der Lichtleitplatte zugewandt ist; und
eine erste Leiterplatte (201, 301, 401, 601), die sich von dem Berührungssensor aus erstreckt, wobei die Lichtquelle an einer Oberfläche der ersten Leiterplatte angebracht ist.

14. Tastenfeldanordnung nach Anspruch 10, die des Weiteren umfasst:
eine Lichtquelle (502), die an dem Schalterelement (510) angeordnet ist, wobei die Lichtquelle eine Licht emittierende Fläche hat, die einer seitlichen Flasche der Lichtleitplatte zugewandt ist; und
eine erste Leiterplatte (501), die elektrisch mit dem Berührungssensor (520) verbunden ist.

15. Tastenfeldanordnung nach Anspruch 10, die des Weiteren wenigstens ein Reflektionsmuster (223, 322a, 422a, 522a, 622a) umfasst, das an einem Abschnitt der Lichtleitplatte (222, 322, 422, 522, 622) ausgebildet ist.

16. Tastenfeldanordnung nach Anspruch 10, wobei die oberen Elektroden (221 a, 330, 430, 530, 630) aus einem leitenden Polymer bestehen und das leitende Polymer in einem sichtbaren Strahlenbereich transparent ist.

17. Tastenfeldanordnung, die umfasst:
einen Berührungssensor (220, 320, 420, 620) und ein Schalterelement (210, 310, 410, 610), das unter dem Berührungssensor angeordnet ist, und **dadurch gekennzeichnet, dass** der Berührungssensor eine Lichtleitplatte (222, 322, 422, 622), eine obere Elektrode (221 a, 321, 421, 621), die an einer oberen Fläche der Lichtleitplatte angeordnet ist, und eine obere Ummantelung (222a, 321 421, 621) umfasst, die so konfiguriert ist, dass sie die obere Fläche der Lichtleitplatte zusammen mit der oberen Elektrode abdeckt;
wobei die Tastenfeldanordnung des Weiteren umfasst:
eine Lichtquelle (202, 302, 402, 602) mit einer Licht emittierenden Fläche, die einer seitlichen Fläche der Lichtleitplatte zugewandt ist; und
eine erste Leiterplatte (201, 301, 401, 601), die sich von dem Berührungssensor aus erstreckt, wobei die Lichtquelle an einer Oberfläche der ersten Leiterplatte angebracht ist.

18. Tastenfeldanordnung nach Anspruch 17, wobei das Schalterelement umfasst:
eine zweite Leiterplatte (612), an der wenigstens ein elektrischer Kontakt (612a) ausgebildet ist;
eine Haubenfolie (611), die auf der zweiten Leiterplatte (612) angeordnet ist und mit Hauben (211 a) versehen ist, die den elektrischen Kontakten entsprechen; und
Vorsprünge (611 a), die an jeweiligen Hauben angeordnet sind.

19. Tastenfeldanordnung nach Anspruch 17, wobei die Tastenfeldanordnung so eingerichtet ist, dass sie selektiv elektrische Kontakt von dem Berührungssensor oder dem Schalterelement verwendet.

## Revendications

1. Ensemble à clavier comportant :
un clavier (230) ;
un capteur tactile (220, 320, 420, 520, 620), et
un élément de commutation (210, 310, 410, 510, 610) disposé en dessous du capteur tactile, **caractérisé en ce que** le capteur tactile comporte une plaque (222, 322, 422, 522, 622) de guidage de lumière ayant au moins une première électrode (221a, 330, 430, 530, 630) et disposée en dessous du clavier afin de réfléchir vers le clavier de la lumière tombant sur la plaque de guidage de lumière,
dans lequel la, au moins une, électrode est interposée entre la plaque de guidage de lumière et le clavier.

2. Ensemble à clavier selon la revendication 1, comportant en outre :
une source de lumière (202, 302, 402, 602) ayant une surface d'émission de lumière qui fait face à une surface latérale de la plaque (222, 322, 422, 622) de guidage de lumière ; et
une première plaquette (201, 301, 401, 601) à circuit imprimé supportant la source de lumière par rapport à la plaque de guidage de lumière, la première plaquette à circuit imprimé étant connectée électriquement au capteur tactile.

3. Ensemble à clavier selon la revendication 1, dans lequel le capteur tactile (220) comporte :
une seconde électrode (221b) disposée en dessous de la plaque de guidage de lumière (222).

4. Ensemble à clavier selon la revendication 3, dans lequel les électrodes supérieure et inférieure (221a, b) sont réalisées en un polymère conducteur, le polymère conducteur étant transparent dans une bande de longueurs d'ondes de rayons visibles.

5. Ensemble à clavier selon la revendication 1, dans lequel l'élément de commutation (210, 310, 410, 510, 610) comporte :
une seconde plaquette à circuit imprimée (212, 312, 412, 512, 612) ayant au moins un contact électrique (212a, 312a, 412a, 512a, 612a) ; et
une feuille à dômes (211, 311, 411, 511, 611) disposée sur la seconde plaquette à circuit imprimé et pourvue de dômes (211a) qui correspondent aux contacts électriques.

6. Ensemble à clavier selon la revendication 1, dans lequel la plaque de guidage de lumière comporte :
une âme (222b) ;
un revêtement supérieur (221a, 222a, 321, 421, 521, 621) disposé au-dessus de l'âme ; et
au moins un motif de réflexion (223, 322a, 422a, 522a, 622a).

7. Ensemble à clavier selon la revendication 6, dans lequel le motif à réflexion est disposé sur une partie d'une surface de l'âme (222b) et est configuré de façon à réfléchir de manière irrégulière une partie de la lumière tombant sur une surface latérale de la plaque de guidage de lumière vers le revêtement supérieur.

8. Ensemble à clavier selon la revendication 7, dans lequel la plaque de guidage de lumière comporte en outre un revêtement inférieur (222c, 323, 423, 523) disposé en dessous de l'âme.

9. Ensemble à clavier selon la revendication 1, dans lequel le capteur tactile est un capteur tactile du type à capacité électrostatique.

10. Ensemble à clavier comportant :
un capteur tactile (220, 320, 420, 520), et
un élément de commutation (210, 310, 410, 510) disposé en dessous du capteur tactile, **caractérisé en ce que** le capteur tactile comporte une plaque de guidage de lumière (222, 322, 422, 522) ; des électrodes supérieures (221a, 330, 430, 530) disposées sur une surface supérieure de la plaque de guidage de lumière ; un revêtement supérieur (222a, 321, 421, 521) recouvrant la surface supérieure de la plaque de guidage de lumière en même temps que les électrodes supérieures ; une électrode inférieure (221b) disposée sur une surface inférieure de la plaque de guidage de lumière ; et un revêtement inférieur (222c, 323, 423, 523) disposé sur la surface inférieure de la plaque de guidage de lumière.

11. Ensemble à clavier selon la revendication 10, dans lequel les revêtements supérieur et inférieur sont réalisés en un polymère ayant un indice de réfraction inférieur à celui de la plaque de guidage de lumière.

12. Ensemble à clavier selon la revendication 10, dans lequel le revêtement inférieur (323, 423, 523) comporte des saillies (323a, 423a, 523a) s'étendant dans une direction orientée verticalement vers le bas, le revêtement inférieur étant disposé de façon à correspondre aux électrodes supérieures.

13. Ensemble à clavier selon la revendication 10, comportant en outre :
une source de lumière (202, 302, 402, 602) ayant une surface d'émission de lumière tournée vers une surface latérale de la plaque de guidage de lumière ; et
une première plaquette à circuit imprimé (201, 301, 401, 601) s'étendant depuis le capteur tactile, la source de lumière étant montée sur une surface de la première plaquette à circuit imprimé.

14. Ensemble à clavier selon la revendication 10, comportant en outre :
une source de lumière (502) disposée sur l'élément de commutation (510), la source de lumière ayant une surface d'émission de lumière tournée vers une surface latérale de la plaque de guidage de lumière ; et
une première plaquette à circuit imprimé (501) connectée électriquement au capteur tactile (520).

15. Ensemble à clavier selon la revendication 10, comportant en outre au moins un motif de réflexion (223, 322a, 422a, 522a, 622a) formé sur une partie de la plaque de guidage de lumière (222, 322, 422, 522, 622).

16. Ensemble à clavier selon la revendication 10, dans lequel les électrodes supérieures (221a, 330, 430, 530, 630) sont réalisées en un polymère conducteur, le polymère conducteur étant transparent dans un domaine de rayons visibles.

17. Ensemble à clavier comportant :
un capteur tactile (220, 320, 420, 620) et un élément de commutation (210, 310, 410, 610) positionné en dessous du capteur tactile, **caractérisé en ce que** le capteur tactile comporte une plaque de guidage de lumière (222, 322, 422, 622), une électrode supérieure (221a, 321, 421, 621) positionnée sur une surface supérieure de la plaque de guidage de lumière, et un revêtement supérieur (222a, 321, 421, 621) configuré de façon à recouvrir la surface supérieure de la plaque de guidage de lumière en même temps que l'électrode supérieure; l'ensemble à clavier comportant en outre :
une source de lumière (202, 302, 402, 602) ayant une surface d'émission de lumière qui est tournée vers une surface latérale de la plaque de guidage de lumière ; et
une première plaquette à circuit imprimé (201, 301, 401, 601) s'étendant depuis le capteur tactile, la source de lumière étant montée sur une surface de la première plaquette à circuit imprimé.

18. Ensemble à clavier selon la revendication 17, dans lequel l'élément de commutation comporte :
une seconde plaquette à circuit imprimé (612) ayant au moins un contact électrique (612a) formé sur elle ;
une feuille à dômes (611) disposée sur la seconde plaquette à circuit imprimé (612) et pourvue de dômes (211a) qui correspondent aux contacts électriques ; et
des saillies (611a) disposées sur des dômes respectifs.

19. Ensemble à clavier selon la revendication 17, lequel ensemble à clavier est conçu pour utiliser sélectivement des contacts électriques provenant de l'un du capteur tactile et de l'élément de commutation.
